Europäisches Patentamt

European Patent Office

Office européen des brevets

(11) Veröffentlichungsnummer: **0 279 432 B1**

# EUROPÄISCHE PATENTSCHRIFT

(45) Veröffentlichungstag der Patentschrift: **13.05.92**

(21) Anmeldenummer: **88102319.6**

(22) Anmeldetag: **18.02.88**

(51) Int. Cl.⁵: **H05K 3/24**, H05K 3/34, G02F 1/1345

---

(54) **Verfahren zur Herstellung einer stromlos abgeschiedenen, lötbaren Metallschicht.**

---

(30) Priorität: **19.02.87 DE 3705251**

(43) Veröffentlichungstag der Anmeldung:
**24.08.88 Patentblatt 88/34**

(45) Bekanntmachung des Hinweises auf die Patenterteilung:
**13.05.92 Patentblatt 92/20**

(84) Benannte Vertragsstaaten:
**DE FR NL**

(56) Entgegenhaltungen:
EP-A- 0 083 458     EP-A- 0 132 784
EP-A- 0 220 541     BE-A- 627 914
DE-A- 2 807 350     DE-B- 2 302 194
FR-A- 2 486 064

(73) Patentinhaber: **Nokia Unterhaltungselektronik (Deutschland) GmbH**
**Östliche Karl-Friedrich-Strasse 132**
**W-7530 Pforzheim(DE)**

(72) Erfinder: **Schlipf, Michael, Dr.**
**Epplerinweg 31**
**W-7060 Schorndorf(DE)**
Erfinder: **Zondler, Rolf, Dr.**
**Marabustrasse 26**
**W-7000 Stuttgart 50(DE)**

## Beschreibung

Die Erfindung bezieht sich auf ein Verfahren zur Herstellung einer stromlos abgeschiedenen, lötbaren Metallschicht auf transparenten Leiterbahnen aus Indium-/Zinnoxid auf Substraten gemäß dem Oberbegriff des Anspruchs 1. Ein solches Verfahren ist aus der EP-A-0 083 458 bekannt.

Aus der DE-PS 28 07 350 ist eine Flüssigkristall-Anzeigevorrichtung bekannt, die ein Glassubstrat als Träger für die Anzeigevorrichtung und für einen integrierten Schaltkreis (IC-Chip) aufweist. Auf dem Glassubtrat sind transparente Leiterbahnen aus Indiumoxid vorhanden. Die lötbare Metallisierung dieser Leiterbahnen im nicht sichtbaren Bereich der Anzeigevorrichtung erfolgt derart, daß zwei chromhaltige Zwischenschichten aufgebracht werden, um darauf eine Goldauflage aufzubringen. Auf dem IC-Chip ist dann noch eine Kontaktierungsschicht aus fünf Schichten vorgesehen, die aus Chrom, Kupfer, Gold, Kupfer bzw. Blei/Zinn bestehen. Als Verfahren zur Metallisierung der Leiterbahnen bzw. des Aufbringens der Schichten ist beispielsweise die Verdampfungstechnik oder das Aufsprühverfahren genannt. Diese Verfahren erfordern einen hohen energetischen und technischen Aufwand.

Aus der DE-AS 23 02 194 ist die Herstellung von Dünnfilm-Schaltungen mittels Fotoätzverfahren bekannt, bei dem auf ein Substrat eine dünne Zwischen- bzw. Haftschicht und eine obere Edelmetallschicht abgeschieden wird. Das Abscheiden der Schichten kann durch Aufdampfen, Aufstäuben oder eine chemische Abscheidung erfolgen.

Aus der DE-AS 25 09 912 ist eine elektronische Dünnfilmschaltung mit einer aus einem Isolatormaterial bestehenden Substratplatte bekannt. Beim Verfahren zum Herstellen der Dünnfilmschaltung wird unter anderem auch auf eine Kupferschicht eine Nickelschicht und auf diese eine Goldschicht stromlos abgeschieden.

Der Erfindung liegt die Aufgabe zugrunde, ein einfacheres Verfahren zur Herstellung einer stromlos abgeschiedenen, lötbaren Metallschicht auf transparenten Leiterbahnen aus Indium-/Zinnoxid auf Substraten der eingangs genannten Art anzugeben.

Die Lösung dieser Aufgabe erfolgt durch ein Verfahren mit den Merkmalen des Anspruches 1. Vorteilhafte Ausgestaltungen der Erfindung sind in den Unteransprüchen 2 bis 6 enthalten.

Die Erfindung wird nun beispielsweise anhand von Figuren näher erläutert. Es zeigen:

Fig. 1 eine Draufsicht auf eine Anzeigevorrichtung und

Fig. 2 das teilweise Eintauchen der Anzeigevorrichtung in ein Bad.

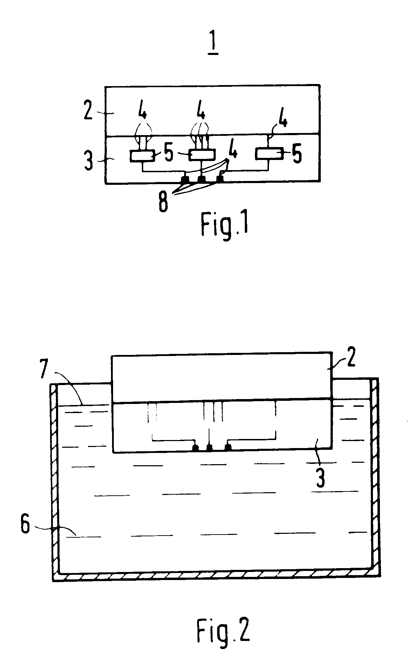

Die in Fig. 1 dargestellte Anzeigevorrichtung 1 weist einen Anzeigebereich 2 und einen im späteren, eingebauten Zustand der Anzeigevorrichtung nicht sichtbaren Bereich 3 auf. Der Anzeigebereich besteht beispielsweise aus einer Flüssigkristallanzeige (nicht dargestellt), die auf einem Substrat, beispielsweise aus Glas, aufgebaut ist. Dieses Substrat ist auch im Bereich 3 vorhanden und trägt dort Leiterbahnen 4, die zu Bauelementen 5, beispielsweise integrierten Schaltungen, und Anschlüssen 8 der Anzeigevorrichtung 1 führen. Die Anschlüsse der Bauelemente 5 sind mit den Leiterbahnen 4 durch Löten oder durch Kleben mit einem Leitkleber verbunden. Für diese Verbindung der Bauelemente 5 mit den Leiterbahnen 4 ist es notwendig, daß die Leiterbahnen eine entsprechende Metallisierung aufweisen.

Die im Anzeigebereich 2 der Anzeigevorrichtung 1 vorhandenen Elektroden bestehen aus einer transparenten, elektrisch leitenden Schicht aus Indium-Zinnoxid. Die Leiterbahnen 4 im Bereich 3 bestehen aus dem gleichen Material, da dann die Herstellung der Elektroden im Anzeigebereich 2 und der Leiterbahnen 4 im Bereich 3 gleichzeitig erfolgen kann. Da aber Leiterbahnen aus Indium-Zinnoxid keine lötfähige Oberfläche aufweisen, sind sie zu metallisieren.

Der Anzeigebereich 2 der Anzeigevorrichtung 1 wird gefertigt und geprüft. Die einwandfreien Anzeigevorrichtungen weisen in diesem Zustand im Bereich 3 noch keine Bauelemente 5 auf. Vor dem Metallisieren der Leiterbahnen 4 kommt die Anzeigevorrichtung in eine Bearbeitungsstation in der die nicht metallischen Oberflächen der Leiterbahnen 4 aktiviert werden, um ein chemisches Metallisierungsbad anwenden zu können. Das Aktivieren geschieht durch Eintauchen des Bereiches 3 in ein Bad, das $PdCl_2/SnCl_2$ enthält. Beispielsweise kann hierfür das Bad "Dynaplate Aktivator" der Firma Schlötter verwendet werden.

In Fig. 2 ist das Eintauchen der Anzeigevorrichtung 1 in ein schematisch dargestelltes Bad 6 gezeigt. Die Anzeigevorrichtung wird dabei gerade so weit in das Bad 6 eingetaucht, daß die Badoberfläche 7 mit der Grenzlinie zwischen dem Anzeigebereich 2 und dem Bereich 3 zusammenfällt.

Anschließend ist es erforderlich, überschüssige Palladium- und Zinnverbindungen in einem Konditionierschritt zu entfernen. Hierzu wird die gesamte Anzeigevorrichtung oder der Bereich 3 in ein Konditionierbad getaucht. Es kann beispielsweise das Bad "Dynaplate Conditioner" der Fa. Schlötter verwendet werden.

Bei der Aktivierung der Leiterbahnen 4 erfolgt auch eine geringe Aktivierung der Glasoberfläche des Substrates im Bereich 3. Um die Glasoberfläche im Bereich 3 wieder zu desaktivieren, wird diese in ein Bad, das Flußsäure enthält, eingetaucht. Dabei erfolgt ein Abätzen der Oberflächenschicht auf dem Glas. Vorzugsweise ist eine 0,1 bis 5%ige Flußsäure zu verwenden, da diese die Leiterbahnen 4 nicht angreift. Insbesondere eignet sich eine 0,8 bis 1,2%ige Flußsäure.

Nach dieser Vorbehandlung erfolgt der Metallisierungsschritt mit Hilfe eines chemischen Metallisierungsbades, beispielsweise des Bades "Novotect" der Fa. Schering, mit dem z.B. eine Nickelschicht auf den Leiterbahnen 4 abgeschieden wird. Das Eintauchen der Anzeigevorrichtung 1 in das Metallisierungsbad geschieht in einer ähnlichen Bearbeitungsstation, wie sie in Fig. 2 dargestellt ist. Die abgeschiedene Nickelschicht hat etwa eine Dicke von 0,2 bis 1 $\mu$m.

Eine typische Badzusammensetzung für das Abscheiden von Nickel ist folgende:

30 g/l $NiCl_2 \times 6\,H_2O$
10 g/l $NaH_2PO_2$
100 g/l Natriumcitrat
50 g/l $NH_4Cl$
pH 8-10

Nach dem Metallisieren werden die Bauelemente 5 auf den Bereich 3 aufgebracht und ihre Anschlüsse durch Löten oder Kleben mit den Leiterbahnen 4 verbunden, so daß eine mit den Bauelementen zu einer Baueinheit verbundene Anzeigevorrichtung entsteht.

## Patentansprüche

1. Verfahren zur Herstellung einer stromlos abgeschiedenen, lötbaren Metallschicht auf transparenten Leiterbahnen aus Indium-Zinnoxid auf dem bei fertigen Anzeigevorrichtungen nicht sichtbaren Teil eines Substrates, **dadurch gekennzeichnet,** daß die Oberfläche der Leiterbahnen (4) durch Tauchen dieses Teils (3) des Substrates in ein Bad aus Palladium- und Zinn (II) chlorid aktiviert wird, daß nach dem Aktivieren der Leiterbahnen (4) überschüssige Zinnund Palladium verbindungen entfernt werden, daß danach durch Tauchen dieses Teils (3) des Substrates in Flußsäure die von den Leiterbahnen (4) nicht bedeckten Flächen desaktiviert werden und daß dann das stromlose Abscheiden der Metallschicht erfolgt.

2. Verfahren nach Anspruch 1, dadurch gekennzeichnet, daß das Entfernen der Zinn- und Palladium verbindungen durch Tauchen des Substrates in ein Konditionierbad erfolgt.

3. Verfahren nach Anspruch 1, dadurch gekennzeichnet, daß eine 0,1 bis 5%ige Flußsäurelösung verwendet wird.

4. Verfahren nach Anspruch 3, dadurch gekennzeichnet, daß eine 0,8 bis 1,2%ige Flußsäurelösung verwendet wird.

## Claims

1. A method of producing a solderable metal layer by means of currentless precipitation on transparent conductor strips made of indium/tin oxide on the part of a substrate that is not visible in a finished display device,
 **characterized in that**
 the surface of the conductor strips (4) is activated by dipping the said part (3) of the substrate into a bath of palladium and tin (II) chloride, that this activation is followed by the removal of any excess quantities of the tin and palladium compounds, that the surfaces not covered by conductor strips (4) are then deactivated by dipping the substrate into hydrofluoric acid, and that the metal layer is thereafter applied by currentless precipitation.

2. A method in accordance with Claim 1,
 **characterized in that**
 the removal of the tin and palladium compounds is obtained by means of dipping into a conditioning bath.

3. A method in accordance with Claim 1,
 **characterized in that**
 a 0.1 to 5% solution of hydrofluoric acid is used.

4. A method in accordance with Claim 1,
 **characterized in that**
 a 0.8 to 1,2% solution of hydrofluoric acid is used.

## Revendications

1. Procédé pour la production d'une couche métallique à séparation autocatalytique, brasable, sur des pistes conductives transparentes en oxyde d'étain d'indium sur la partie non visible d'un substrat sur des dispositifs d'affichage achevés, **caractérisé en ce que** la surface des pistes conductives (4) est activée par trempage de cette pièce (3) du substrat dans un bain de chlorure palladeux et de chlorure stanneux, qu'après avoir activé les pistes conductives (4), des combinaisons d'étain et de palladium excédentaires sont éliminées, qu'ensuite par trempage de cette partie (3) du substrat dans de l'acide fluorhydrique, les surfaces non couvertes par les pistes conductives (4) sont désactivées et qu'après a lieu la séparation autocatalytique de la couche métallique.

2. Procédé selon la revendication 1, caractérisé en ce que les combinaisons d'étain et de palladium sont éliminées par trempage du substrat dans un bain de conditionnement.

3. Procédé selon la revendication 1, caractérisé en ce que on utilise une solution d'acide fluorhydrique de 0,1 à 5 %.

4. Procédé selon la revendication 3, caractérisé en ce que on utilise une solution d'acide fluorhydrique de 0,8 à 1,2 %.

Fig.1

Fig.2